# EUROPEAN PATENT APPLICATION

(11) **EP 4 199 358 A1**
(43) Date of publication of application: **21.06.2023**
(21) Application number: 21216106.1
(22) Date of filing: 20.12.2021
(51) Int. Cl.: H03M 1/10, H03M 1/78

(54) **LINEAR DAC BY INPUT CODE MODIFICATION**

(71) Applicant: Goodix Technology (HK) Company Limited, Sheung Shui (HK)
(72) Inventor: Schuurmans, Han Martijn, 6537 TL Nijmegen (NL)
(74) Representative: Nederlandsch Octrooibureau

(57) **Abstract**

The present disclosure relates to a Digital-to-Analog Converter (DAC) circuit for outputting an voltage comprising a plurality of current providing means connected such that an output current of an each of the current providing means is half of an output current of subsequent current providing means; a plurality of first switching means connected to each of the current providing means, respectively; each first switching means configured to divert each current into a first path or a second path based on a control signal; and control means connected to the plurality of first switching means, and configured to: receive a binary input signal, the binary input signal comprising a plurality of bits ranging from a most significant bit, MSB, to a least significant bit, LSB, and wherein each bit is associated to a switching means among the plurality of first switching means; receive an error associated with the MSB; and modify, when the MSB is set to 1, the binary input signal to generate the control signal based on the binary input signal and the error associated with the MSB, such that a current diverted by at least one of first switching means compensates the error associated with the MSB; wherein an output voltage is generated based on currents in the first path and the second path.

## Description

### TECHNICAL FIELD

The present invention relates to a Digital-to-Analog Converter (DAC) circuit.

### BACKGROUND ART

Smartphone cameras have developed rapidly over the past decade, becoming more and more compact while improving quality and resolution. The movement of the lens allows to focus, zoom and stabilize the image. These days, the auto-focus (AF) has become the basic function. An AF driver in general applies a direct current (DC) to a so called voice coil motor (VCM). The VCM is driven in response to a voltage typically regulated by a Digital-to-Analog Converter (DAC) circuit and the resolution of the DAC circuit gives the granularity of the lens position. Commonly, the resolution of a DAC circuit is given by the number of bits, N, and indicates the smallest increment of output that the DAC circuit can produce.

It is known (e.g. WO2011081966 A2), that in a R-2R ladder DAC circuit including a single resistive rung for each bit of a digital input signal, the consecutive resistive rungs are descending size-scaled from the Most Significant Bit (MSB) to the Less Significant Bit (LSB). As a result, the area of the R-2R ladder DAC circuit can be reduced based on the significant decrease in the physical size of the resistors resulting from the descending size-scaling. When more resistive rung (bits) are added to an already R-2R ladder DAC circuit, the new added resistive rungs add errors that are corrected by adding more electrical components, as current sources. These extra electrical components increase the physical size of the DAC circuit.

### SUMMARY

According to the invention, there is provided a DAC circuit for outputting an voltage comprising a plurality of current providing means connected such that an output current of an each of the current providing means is half of an output current of subsequent current providing means; a plurality of first switching means connected to each of the current providing means, respectively; each first switching means configured to divert each current into a first path or a second path based on a control signal; and control means connected to the plurality of first switching means, and configured to: receive a binary input signal, the binary input signal comprising a plurality of bits ranging from a most significant bit, MSB, to a least significant bit, LSB, and wherein each bit is associated to a switching means among the plurality of first switching means; receive an error associated with the MSB; and modify, when the MSB is set to 1, the binary input signal to generate the control signal based on the binary input signal and the error associated with the MSB, such that a current diverted by at least one of first switching means compensates the error associated with the MSB; wherein an output voltage is generated based on currents in the first path and the second path. By controlling the switching means, the error can be efficiently compensated. Such arrangement is believed to be considerably more versatile in minimizing the size required for the DAC circuit while the resolution is increased. As a result, an increase in resolution does not require increasing the size of the DAC circuit for compensating errors. Thereby, lowering the cost of such DAC circuits.

In an example of the present disclosure, the control means compensate the error associated with the MSB by controlling at least one first switching means among the plurality of first switching means that provides a current corresponding to the binary input signal and the error associated to the MSB.

In an example of the present disclosure, the plurality of current providing means are a plurality of current dividers connected such that an output current from each of the current dividers is an input current of subsequent current divider.

In an example of the present disclosure, the control means is connected to a plurality of current sources and corresponding second switching means, and the control means is configured to control the second switching means such that a current generated by the plurality of current sources compensate the error associated with the MSB. Optionally, each current source among the the plurality of current sources generates a current equivalent to a current provided by a current divider corresponding to the LSB.

In an example of the present disclosure, the control means is further configured to: receive an error associated with a next MSB; and generate the control signal further based on the error associated with the next MSB, such that when the next MSB is set to 1, a current is transmitted by the plurality of current dividers that compensate the error associated with the next MSB.

In an example of the present disclosure, the control means is configured to reduce a current provided by a current divider corresponding to the MSB. Optionally, the control means can be configured to reduce a current provided by a current divider corresponding to the next MSB. By reducing the current, it is ensured that the current can be corrected by adding a current corresponding to the error.

In an example of the present disclosure, the plurality of current providing means and switching means forms a R-2R ladder. By using a R-2R ladder, the DAC circuit is easier to build accurately as only two type of resistors are required and the number of bits can be expanded by adding sections of same type of resistors.

In an example of the present disclosure, the plurality of current providing means are: a plurality of current sources such that a current of a current source is double than a current of a consecutive current source; and a current divider configured to divide an input current into a first output current and a second output current, wherein the first output current is double that the second output current, and the second output current is double than a current of a first current source among the plurality of current sources.

In an example of the present disclosure, the error is a multiple of a current transmitted to a switching means corresponding to the LSB.

In an example of the present disclosure, the error associated with the MSB is stored in a non-volatile memory. Optionally, the error associated with the next MSB is stored in the non-volatile memory. By storing the error in such a memory, it is ensure that the value of the error can be obtained from the even after power is removed. Hence, the error value does not need to be stored every time the power is removed, thereby saving time and the necessity of inputting such value every time the DAC circuit is in use.

In an example of the present disclosure, the first path and the second path are connected to an operational amplifier (OPAMP) for outputting an output current.

In an example of the present disclosure, a voice coil motor (VCM) is provided. The VCM comprising a DAC circuit, such that the voice coil motor is configured to be controllable by an output current of the DAC circuit.

### BRIEF DESCRIPTION OF DRAWINGS

The invention will be described in more detail below, with reference to preferred embodiments as shown in the drawings attached, in which:
Fig. 1 shows block diagram of a DAC circuit
Fig. 2 shows a DAC circuit implemented by a R-2R ladder architecture for 10 bits.
Fig. 3 shows a DAC circuit implemented by a R-2R ladder architecture for 12 bits.
Fig. 4 shows MSB and MSB-1 transition errors and DNL errors for all transitions
Fig. 5A and 5B show a Dynamic Non Linearity (DNL) error for a MSB transition and for a MSB-1 transition.
Fig. 6A and 6B show a DNL error for a MSB transition when DNL error of a MSB-1 transition is already corrected.
Fig. 7A and 7B show a MSB transition and a MSB-1 transition when both DNL errors for the MSB transition and the MSB-1 transition are corrected.
Fig. 8 shows another DAC circuit implemented by a R-2R ladder architecture
Fig. 9 shows a DAC circuit implemented by a Binary Weighted Current architecture.
FIG. 10 shows a diagram of a method (1000) of a Digital-to-Analog Converter (DAC) circuit (10) for outputting a voltage.

### DESCRIPTION OF EMBODIMENTS

The aspects of the present disclosure will now be described more fully hereinafter with reference to the accompanying drawings, in which certain embodiments of the disclosure are shown.

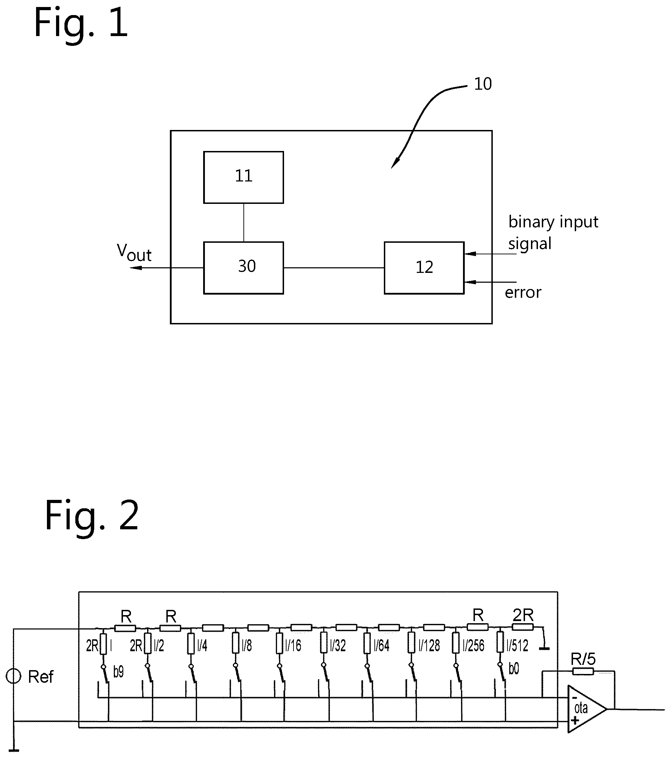

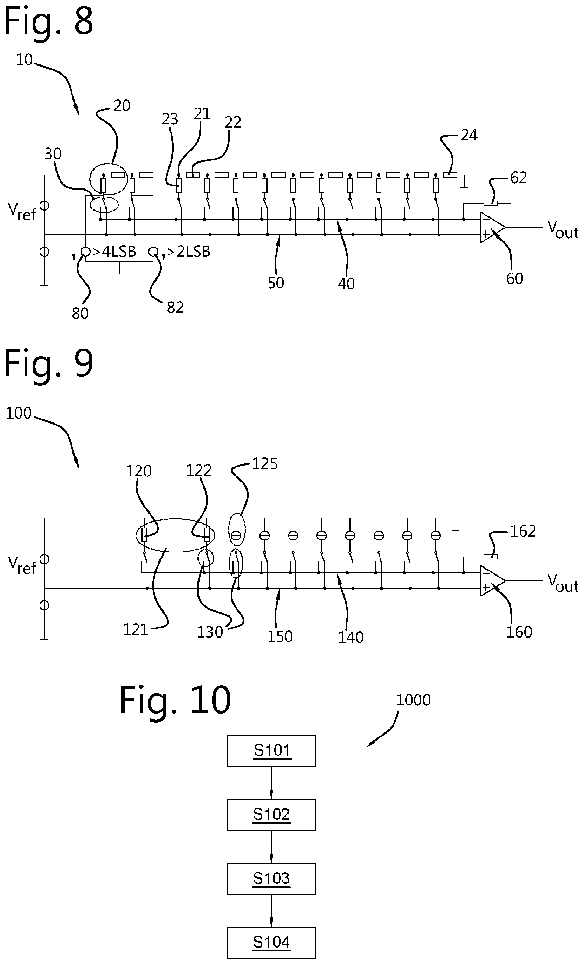

A Digital-to-Analog Converter (DAC) circuit is used to transform digital data into an analog signal. There are several architectures used for digital to analog conversion, FIG. 2-3 and 8 show a R-2R ladder network architecture and FIG. 9 shows a Binary Weighted Current architecture. Although the present disclosure will be described with reference to these two architectures, the skilled person would understand that other architectures can be used. Furthermore, although the examples shown in FIG. 2 to 8 are described with respect to a DAC circuit, the present disclosure is intended to be implemented in an Analog to Digital Converter (ADC) circuit, a coder-decoder (CODEC) circuit, radio-frequency (RF) circuitry, power amplifier circuit, voltage regulator circuit, and the like.

FIG. 1 shows block diagram of a DAC circuit 10 for outputting a voltage. The DAC circuit 10 comprises a plurality of current providing means 11, a plurality of first switching means 30 and a control means 12. The plurality of current providing means 11 is connected such that an output current of an each of the current providing means is half of an output current of subsequent current providing means. The plurality of first switching means 30 is connected to each of the current providing means, respectively. Each first switching means is configured to divert each current into a first path or a second path based on a control signal. The control means 12 is connected to the plurality of first switching means. The control means 12 is configured to receive a binary input signal, the binary input signal comprising a plurality of bits ranging from a most significant bit, MSB, to a least significant bit, LSB, wherein each bit is associated to a switching means among the plurality of first switching means; receive an error associated with the MSB; and modify, when the MSB is set to 1, the binary input signal to generate the control signal based on the binary input signal and the error associated with the MSB, such that a current diverted by at least one of first switching means 30 compensates the error associated with the MSB. The output voltage is generated based on currents in the first path and the second path.

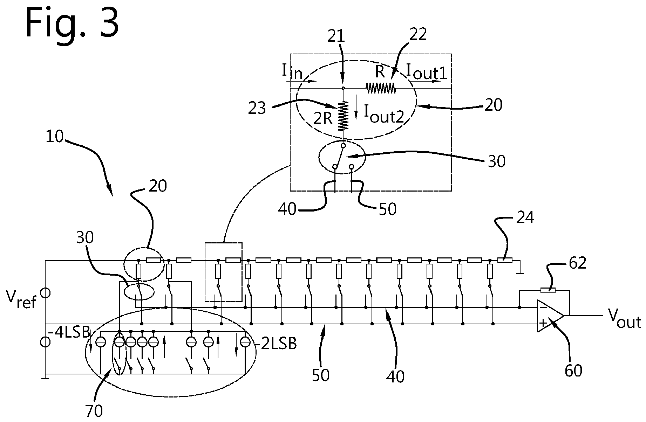

FIGs. 2 and 3 show a DAC circuit implemented by a R-2R ladder architecture, for 10 bits and 12 bits, respectively. The DAC circuit 10 comprises a plurality of current dividers 20 and a plurality of first switching means 30. The plurality of first switching means 30 are connected to each of the current dividers 20, respectively. Each first switch means 30 is configured to divert each second output current into a first path 40 or a second path 50 based on a control signal.

Each current divider 20 receives an input current and outputs a first output current and a second output current. The plurality of current dividers 20 are connected such that a first output current from each of the current dividers is an input current of subsequent current divider. Each current divider 20 comprises a node 21. The node 21 is connected to a node of the subsequent current divider by a first resistor 22 and to a first switching means 30 by a second resistor 23. The first resistor 22 has a resistance value of R and the second resistor 23 has a resistance value of 2R. That is the resistance value of the second resistor 23 is double than the resistance value of the first resistor 22. The node 21 of a first current divider among the plurality of current dividers is connected to a voltage source at which a reference voltage Vref is generated. The node 21 of a last current divider among the plurality of current dividers is connected to a ground line via a last second resistor 24. The last second resistor 24 has the same resistance value as any other second resistor 23, that is has also a resistance value of 2R. The value of R can be any value as long as the ratio R:2R is satisfied. For example, R can be 1 Ohm and 2R can be 2 Ohm. Such a ratio between resistance values of the first resistors 22 and the second resistors 23, is due to the fact that, looking to the right of each first resistor 22, an equivalent resistance Req of the circuit has a resistance value of R as well. By the fact that the equivalent resistance Req of resistance value R, the plurality of current dividers 20 are connected such that consecutively divide the input current by 2 into two equal output current, that is the first output current (i.e. the current flowing through the first resistor 22) is equal to the second output current (i.e. the current flowing through the second resistor 23). As shown in the example of FIG. 2, the current flowing through the first resistor 22 of the first current divider is I, the current flowing through the first resistor 22 of the second current divider is I/2, the current flowing through the first resistor 22 of the third current divider is I/4, and so on (I being any value of current).

The DAC circuit 10 comprises a control means (not shown). The control means is configured to receive a binary input signal having N bits, where N is a positive integer. The total number of current dividers is equal to N. The binary input signal is configured to store the N bits ranging from a most significant bit (MSB) to a least significant bit (LSB). The MSB corresponds to the bit <N-1> (hereinafter b_{N-1}) and the least significant bit (LSB) corresponds to the bit <0> (hereinafter bo). The next most significant bit, hereinafter MSB-1, may refer to the bit <N-2>, (hereinafter b_{N-2}).

The plurality of first switching means 30 are configured to be controlled by the control means such that each first switching mean is controlled based on the binary input signal such that each switching mean diverts the second output current into the first path 40 or the second path 50. For example, when the binary input signal is 101₂ (the sub-index 2 indicates that the number is a base 2 number), then b2 = 1, b1 = 0 and b0=1. The first switching means corresponding to b2, b1 and b0 are controlled such that the second output current of the switching means corresponding to b2 and b0 are diverted to the first path and the second output current of the first switching mean corresponding to b1 is diverted to the second path.

The DAC circuit 10 comprises an operational amplifier (OPAMP) 60 for outputting an output voltage, Vout. Each of the switching means 30 can be controlled to connect to the (+) input, i.e. the non-inverting input, of the OPAMP via the first path 40, or to the (-) input, i.e. the inverting input, of the OPAMP via the second path 50. The output voltage Vout of the OPAMP 60 is *Vout* = *Vref* . (*RF*/*2R*), where RF is the resistance of a feedback resistor 62 connected between the (-) input of the amplifier 60 and the output thereof. The feedback resistor 62 has a resistance value of R/5. The output voltage Vout of the DAC take on only specific values like the 2^{N} possible voltage levels for Vout, wherein N is the number of bit of the binary input signal. Thus, in that sense, it represents a digital value. However, the number of different possible output levels can be increased and the difference between successive values can be decreased by increasing the number of bits of the binary input signal. This allows to produce an output that is an analog quantity that varies continuously over a range of values. Each binary input signal contributes a different amount to the analog output. The weights are successively doubled for each bit, beginning with the LSB.

Resolution of a DAC circuit is defined as the smallest change that can occur in the analog output as a result of a change in the digital input. The resolution is always equal to the weight of the LSB. A DAC is monotonic if its output voltage (e.g. Vout) increases as the binary input signal is incremented from one value to the next.

Ideally, all of the first resistors 22 and all the second resistors 23 resistors have the same resistance value R and 2R, respectively. However, circuit manufacturing process can result in slight variations in the resistance matching level (σ) of each first resistor 22 and second resistor 23 of one current divider 20 relative to the others. Generally, the mismatch between resistors is inversely proportional to the square root of the area of the resistor. This variation in the resistance matching level of the resistors can result in a differential non-linearity (DNL) error in the magnitude of the output voltage (Vout). Specifically, the DNL error is a difference between an actual magnitude and an ideal magnitude of the output voltage Vout. In order to maintain sufficient resolution of the R-2R DAC circuit, it is desirable to maintain a DNL error to within a predetermined fractional portion (e.g., +/-0.5) of a magnitude of one LSB. Typically, the DNL error of an R-2R DAC circuit is proportional to a resistor matching level. For example, a 10 bit linearity is achieved by using a resistor matching level of 0.1%, as a result the DNL error remain within 1 LSB.

In order to increase the resolution of a 10 bit R-2R DAC circuit to a 12 bit R-2R DAC circuit, two more bits can be added. This increase in bits can be done by adding two R-2R sections. A R-2R section comprises a current divider and a switching means (e.g. the first switching means). As a result, the resistor matching level between resistor needs to be increased by a factor of 4, due to the 2 bits increment from 10 bit to 12 bit. Hence, an increment of 2 bits results in a 16 time increases of area.

MSB transition refers to a transition in which the MSB is set to 1, while all remaining bits are set to 0; and a MSB-1 transition refers to a transition in which the next MSB is set to 1, while the MSB and all lower remaining bits are set to 0. This can be seen as the switching means corresponding to the MSB is activated when the MSB is set to 1, and deactivated when the MSB is set to 0. For example, for a 10 bits input signal, the MSB transition refers to a transition from 0111111111₂ to 1000000000₂, and the MSB-1 transition refers to a transition from 0011111111₂ to 0100000000₂. A sub-index 2 indicates that the number is represent in base 2. Similarly, a sub-index 10 indicates that the number is represent in base 10. As previously explained, setting to 1 the MSB bit and setting to 0 the remaining bits, ideally should result in an increase of 1 LSB. One LSB refers to a voltage value equal to an output voltage of the DAC when only the LSB is set to 1 and the remaining bits are set to 0. For example, when two R-2R sections are added in order to increase 10 bit to 12 bit, while the lower 10 bit have 10 bit accuracy, the first added bit (corresponding to a first R-2R section) can have an error of 2 LSB due to matching error and the second added bit has an error of 4 LSB. The actual MSB and MSB-1 currents can be too low or too high that would also result in a non-monotonic DAC at the MSB and MSB-1 transitions.

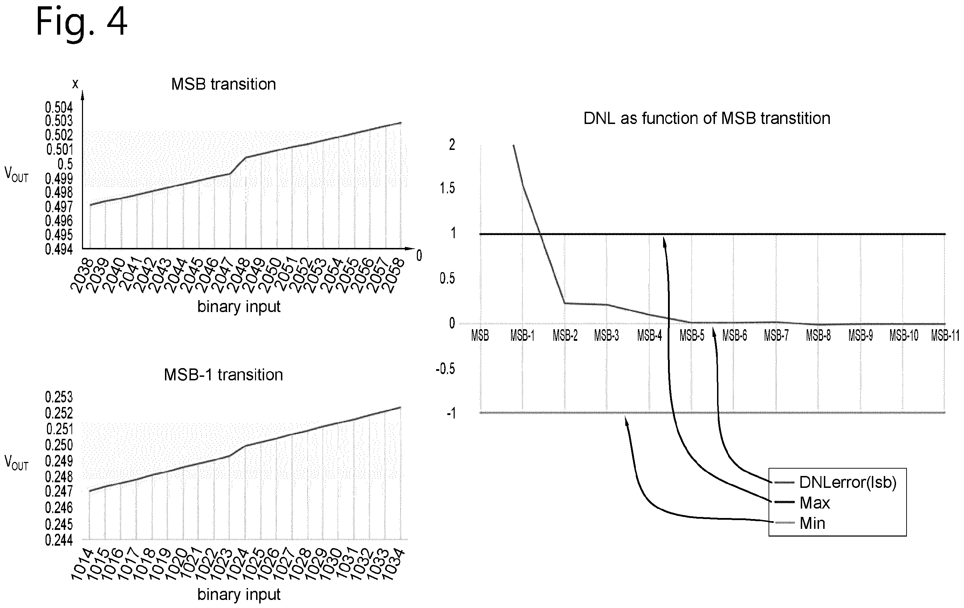

FIG. 4 shows in in the left pictures the MSB and MSB-1 transition errors and the right picture the DNL error for all transitions, of a 12 bits DAC. The MSB and MSB-1 are shown as a random trial with a resistance matching level (also called matching standard deviation) of σ = 0.001. In this trial both currents are too large and it will result in a non-monotonic DAC, as shown in the left pictures of Fig. 4. The output voltage (Vout) increases as the binary input increases. The DNL is shown for all MSB transitions in the right picture of Fig. 4. The DNL error of the lowest transitions (MSB-2 transition,... MSB-11) are lower than DNL error of the MSB transition and the MSB-1 transition. That is DNL error of the MSB transition and the MSB-1 transition are above 1 LSB, and DNL error of the MSB-2 transition,... and MSB-11 are lower than 1 LSB. When the DNL error is between the minimum value (e.g. -1 LSB) and a maximum value (e.g. 1 LSB) the DNL error can be ignored, as it cannot be corrected. When the DNL error is above the maximum value (e.g. 1 LSB) or below the minimum value (e.g. > -1 LSB), the DNL error can be corrected.

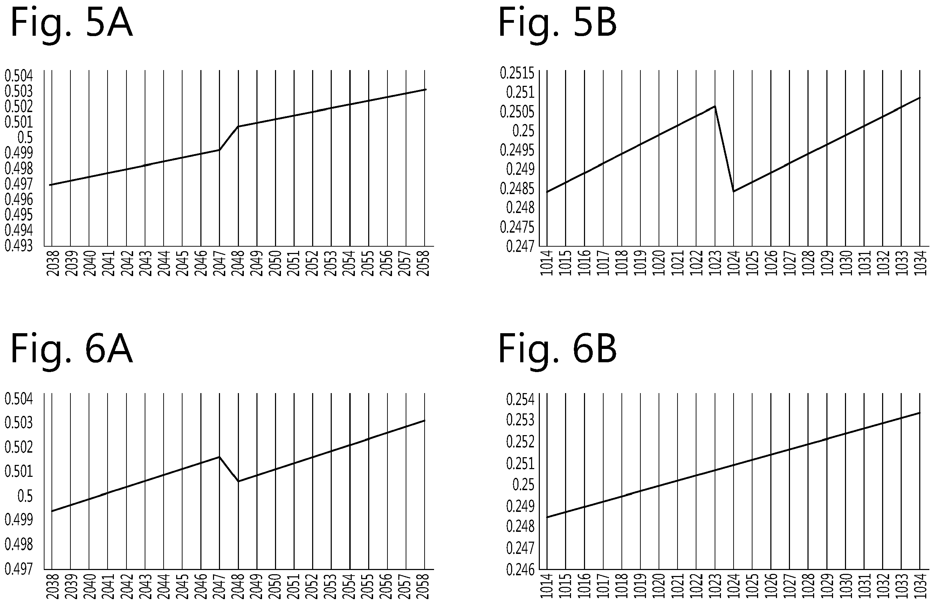

A 12 bits DAC can have 2¹² (i.e. 4096) possible output voltages Vout based on the binary input signal, and each output voltage 1 LSB greater than the previous one. This can be seen as an staircase wave, each step increases 1 LSB. In the example of FIG. 5A and FIG. 5B, the MSB transition has a DNL error of +5 LSB and the MSB-1 transition has a DNL error of -10 LSB. That is, when transitioning from the 2047₁₀ (011111111111₂) to 2048₁₀ (100000000000₂), which corresponds to MSB transition, the output voltage corresponding to 2048₁₀ (1000000000000₂) is 5 times greater than ideally should have. In the case of the MBS-1 transmission, as shown in FIG. 3B, there is an error of -10 LSB when transitioning from the 1023₁₀ (001111111111₂) to 1024₁₀ (010000000000₂), therefore the output voltage corresponding to 1024₁₀ (010000000000₂) is 10 times lower than ideally should have.

As shown in FIG. 6A and FIG. 6B, when the DNL error of MSB-1 transition is corrected, the MSB transition has a DNL error of -5 LSB. This is due to the fact that the DNL error of the MSB transition is influenced by the DNL error of the MSB-1 transition. Therefore, the DNL error of MSB-1 transition needs to be taken into account when correcting MSB transition.

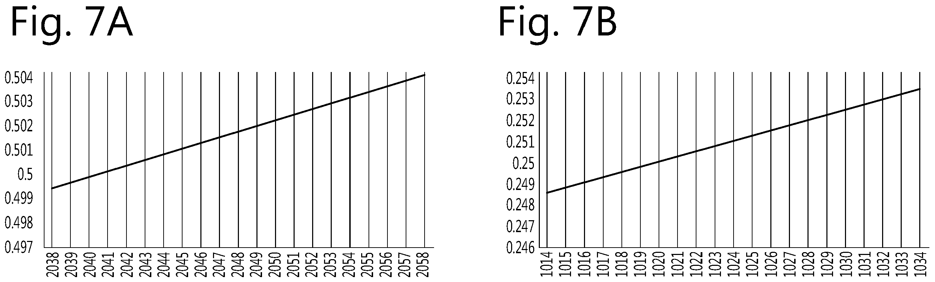

In FIG. 7A and FIG. 7B, when both DNL errors of the MSB and MSB-1 transitions are corrected, the output voltage Vout of the DAC circuit with respect to the binary input signal shows an increased lineal tendency, that is the DAC circuit is monotonic. Thus, when correcting the MSB-1, the output voltage is corrected based on the DNL error of the MSB-1 transition, and when correcting the MSB, the output voltage is corrected based on the DNL error of the MSB transition and the MSB-1 transition. In the present example, the DNL error of the MSB transition and MSB-1 transition are +5 LSB and -10 LSB, respectively, however, the present disclosure is equally intended to cover and include any other value as the value depends on the circuit manufacturing process.

Back to FIG. 3, the lower 10 bits have a DNL error within 1 LSB, while the two added bits corresponding to the MSB and the next MSB have a DNL error greater than 1 LSB. The MSB increases the DNL by a +4 LSB and the next MSB increases the DNL by a +2 LSB. In order to correct there errors, the control means is connected to a plurality of current sources (70) and corresponding second switching means, and is configured to control the second switching means such that a current generated by the plurality of current sources compensate the error associated with the MSB. The DNL error is corrected by adding a current source 70 to compensate the DNL error associated to the MSB and/or the MSB-1. However, this adds area due to the components of the current source 70 and the second switching means.

The DNL error of MSB and MSB-1 are made deliberately smaller. For example, if the DNL error of the MSB transition is 4 LSB and the DNL error of the MSB-1 transition is 2 LSB, the voltage for the MSB is at least 4 LSB smaller and for MSB-1 at least 2 LSB smaller. Because of the MSB and MSB-1 values are made smaller, they can be correct by adding the DNL error in the digital domain. If the current are larger, they cannot be corrected by subtracting currents, as it would result in an MSB transition. In this case, it is needed to add currents for all lower significant bits, which would make it less elegant and more complex.

During the industrial testing of the DAC circuit, the MSB and MBS-1 transitions are measured and stored in a memory as a multiple of LSB. By storing the DNL error as a multiple of the LSB, it is known how many times the output voltage corresponding to the MSB is greater or lower than the ideal 1 LSB. Hence, the control means can easily control at least one first switching means among the plurality of first switching means to provide a current corresponding to the binary input signal and the error associated to the MSB. For example, if an input signal is 10101₂ (i.e. b4=1, b3=1, b2=0, b1 = 0and b0=1) and the DNL error associated to the MSB is -3 LSB, the control means controls the first switching means to **1**1000₂(**1**0101₂ + 11₂ = **1**1000₂). The memory usually is a non-volatile memory. Such memories retain stored data even after power is removed. Examples of non-volatile memories are a non-volatile Random-Access Memory (RAM), Read Only Memory (ROM), Erasable Programmable ROM (EPROM), Electrically Erasable Programmable ROM (EEPROM), and the like.

In the present invention the correction is made via a binary signal (or code) modification which adds a multiple of the LSB value equal to the DNL. This allows to add two R-2R sections to a ten R-2R sections, all section with the same size, without increasing area nor to calibrate the individual resistors.

The correction process can be performed by a hardware or firmware by, for example, the code flow shown below.When the DNL for MSB-1 is e.g -2LSB, -2 will be stored in a memory related to MSB-1 error. When a binary code is introduce in the floe, the error will be added when MSB-1 is set to "1". For example, the binary signal is 1023₁₀ and the binary signal send to the DAC will be 1023₁₀, but when the binary signal is 1024₁₀, the binary signal send to the DAC will be 1024₁₀ + 2₁₀ = 1026₁₀. It means that 2₁₀ needs to be added between 1024₁₀ and 2047₁₀, but also between 3072₁₀ and 4095₁₀. In principle, MSB-1 correction = -1 x DNL_{MSB-1} and MSB correction = -1 x (DNL_{MSB-1} + DNL_{MSB}), wherein DNL_{MSB-1} is the DNL error for the MSB-1, and DNL_{MSB} is the DNL error for the MSB. That is, the error correction is equal to DNL error but with opposite sign. If DNL error is positive, the error correction is negative, and vice versa.

Flow code:
1. Retrieve OTP value of MSB and MSB-1, being DNLMSB and DNLMSB-1
2. Loop
3. Get InputCode ;
4. If InputCode < 1024 OutputCode = InputCode;
5. If 1023 < InputCode < 2048 OutputCode = InputCode - DNL_{MSB-1};
6. If InputCode > 2047 OutputCode = InputCode - DNL_{MSB-1} - DNL_{MSB};
7. If InputCode > 3071 OutputCode = InputCode - 2*DNL_{MSB-1} - DNL_{MSB};
8. Write OutputCode to DAC
9. End Loop

When flow codes is in line 5 the MSB-1 is set to '1', so is active (or on), when flow codes is in line 6 the MSB is set to '1', so is active (or on), and flow codes is in line 7 the MSB and the MSB-1 are set to '1', so both are active (or on).

This flow can be either used for a digital hardware implementation when there is no processor on board or a firmware implementation, when the DAC is directly coupled to a processor.

FIG. 8 shows another DAC circuit comprising control means (not shown). The control means are connected to the plurality of first switching means 30. The plurality of first switching means (30) are configured to divert each current into a first path (40) or a second path (50) based on a control signal generated by the control means. A reduce current 80 indicates that the current (or voltage) flowing through the first switching means 30 associated to the MSB has been reduced by at least 4 LSB, and a reduce current 82 indicates that the current (or voltage) flowing through the first switching means 30 associated to the MSB-1 has been reduced by at least 2 LSB. By reducing the currents, the DNL error of the MSB and/or MSB-1 can be corrected. The control means are configured to compensate the error associated with the MSB by modifying the binary input signal to generate the control signal that controls a current provided by at least one first switching means among the plurality of first switching means corresponding to the binary input signal and the error associated to the MSB. During operation of the DAC circuit, the DNL error value(s) stored in the memory is(are) retrieved and the correction of the error associated with the MSB and/or MSB-1 can be performed by the control means. Example of control means are a hardware, a software and a firmware.

Although the examples shown in FIG. 2 to 6 are described for a 10 bit R-2R DAC circuit to a 12 bit R-2R DAC circuit, it is also intended to a general M bit R-2R DAC circuit to a N bit R-2R DAC circuit, where M<N, and in which the N-M MSBs are corrected by adding a value to the binary input signal, the value being based on the errors of MBS transitions. For example, 8 bit R-2R DAC circuit to 12 bit R-2R DAC circuit would in this case add 4 sections. In general a Mbit to Nbit increase can be done by adding N-M sections, while each added sections have a value of 2¹(1-x₁LSB), 2²(1-x₂LSB) ... 2^{(N-M)} (1-x_{(N-M)}LSB). Here xₙ is a value >= 1, to make sure the added section is not 2" larger, but just a bit smaller, such that the DNL error can be corrected.

The present disclosure can be used to any multi-bit DAC architecture. Also for a binary weighted DAC as explained in FIG. 7. When increasing the resolution from 15bit to 16bit, (M=15, N=16) you could add a non-matched current source with a value of 21(1-1LSB) times larger than bit 15. Instead of using the LSB's of the original DAC itself, it is also possible to make a separate current source to compensate error. Those LSB current sources could be coupled to the OTP without the need for modifying the code. However, this adds area.

FIG. 9 shown a 10 bit DAC circuit implemented by a Binary Weighted Current architecture. The binary weighted resistor DAC uses an OPAMP to sum the binary weighted currents derived from a reference voltage VRref via current scaling resistors. The DAC circuit 100 comprises eight current sources 125, one current divider 120, ten first switching means 130 and control means (not shown). Each first switching mean 130 is connected to each of the current sources and the current divider, respectively. Each first switching mean 130 configured to divert each current into a first path 140 or a second path 150 based on a control signal. Each current source 125 generates a current such that a current of a current source is double than a current of a consecutive current source. That is, the current corresponding to the bit b7 is double that the current corresponding to the bit b6, the current corresponding to the bit b6 is double that the current corresponding to the bit b5, and so on.

The current divider 120 is configured to divide an input current into a first output current and a second output current. A first switching mean 130 is connected to each of the output currents of the current divider. The current divider 120 comprises a first resistor 121 and a second resistor 122. The resistance of the first resistor 121 is R and the resistance of the second resistor 122 is 2R. Such arrangement of resistors allows that the first output current is double that the second output current. The second output current, corresponding to the bit b8, is double than the current corresponding to the bit b7.

The control means are connected to the plurality of first switching means 130, and generate the control signal based on the binary input signal and the error associated with the MSB, such that when the MSB is set to 1, a current is provided that compensate the error associated with the MSB.

The DAC circuit 100 comprises an OPAMP 160. The first path 140 and the second path 150 are connected to the OPAMP 160 for outputting an output current Vout. Each of the switching means 130 can be controlled to connect to the (+) input, i.e. the non-inverting input, of the OPAMP via the first path 140, or to the (-) input, i.e. the inverting input, of the OPAMP via the second path 150. The output voltage Vout of the OPAMP 160 is *Vout* = *Vref* · (*RF*/2*R*), where RF is the resistance of a feedback resistor 162 connected between the (-) input of the amplifier 160 and the output thereof. The feedback resistor 162 has a resistance value of R/5.

The DNL error of bit b9 (i.e. the MSB) and the bit b8 (i.e. the MSB-1) is due to a mismatching among current sources. These DNL errors are measured and stored in a memory during the industrial testing of the DAC circuit.

The DAC circuit of FIG. 1, 2, 3, 8 and 9 can be used for many applications. Many motor controls require voltage control signals, and a DAC is ideal for this application which may be driven by a processor or controller. For example, a voice coil motor (VCM) can be configured to be controlled by an output current of a DAC circuit.

FIG. 10 shows a diagram of a method (1000) of a Digital-to-Analog Converter (DAC) circuit (10) for outputting an voltage, the DAC circuit comprising a plurality of current providing means (11) connected such that an output current of an each of the current providing means is half of an output current of subsequent current providing means; and a plurality of first switching means (30) connected to each of the current providing means, respectively; each first switching means configured to divert each current into a first path (40) or a second path (50) based on a control signal. The step S101 of the method 1000 comprises receiving a binary input signal, the binary input signal comprising a plurality of bits ranging from a most significant bit, MSB, to a least significant bit, LSB, and wherein each bit is associated to a switching means among a plurality of first switching means. The step S102 of the method 1000 comprises receive an error associated with the MSB. The step S103 of the method 1000 comprises modifying, when the MSB is set to 1, the binary input signal to generate a control signal based on the binary input signal and the error associated with the MSB, such that a current diverted by at least one of first switching means compensates the error associated with the MSB. The step S104 of the method 1000 comprises generating an output voltage based on the currents in the first path and the second path.

The invention must not be regarded as being limited to the preferred embodiments described above; a number of further variants and modifications are feasible without departing from the scope of the patent claims. An electrical machine configured according to the present invention may be used wherever a small and efficient electric machine is desired, for example, to control valves on a combustion engine.

## Claims

1. A Digital-to-Analog Converter (DAC) circuit (10) for outputting an voltage comprising:
- a plurality of current providing means (11) connected such that an output current of an each of the current providing means is half of an output current of subsequent current providing means;
- a plurality of first switching means (30) connected to each of the current providing means, respectively; each first switching means configured to divert each current into a first path (40) or a second path (50) based on a control signal; and
- control means (12) connected to the plurality of first switching means, and configured to:
∘ receive a binary input signal, the binary input signal comprising a plurality of bits ranging from a most significant bit, MSB, to a least significant bit, LSB, and wherein each bit is associated to a switching means among the plurality of first switching means;
∘ receive an error associated with the MSB; and
∘ modify, when the MSB is set to 1, the binary input signal to generate the control signal based on the binary input signal and the error associated with the MSB, such that a current diverted by at least one of first switching means compensates the error associated with the MSB;
- wherein an output voltage is generated based on the currents in the first path and the second path.

2. The DAC circuit of claim 1, wherein the control means compensate the error associated with the MSB by controlling at least one first switching means among the plurality of first switching means that provides a current corresponding to the binary input signal and the error associated to the MSB.

3. The DAC circuit of any preceding claim, wherein the plurality of current providing means are a plurality of current dividers (20) connected such that an output current from each of the current dividers is an input current of subsequent current divider.

4. The DAC circuit of claim 1,
- wherein the control means is connected to a plurality of current sources (125) and corresponding second switching means (130), and
- the control means is further configured to control the second switching means such that a current generated by the plurality of current sources compensate the error associated with the MSB.

5. The DAC circuit of claim 4, wherein each current source among the the plurality of current sources generates a current equivalent to a current provided by a current divider corresponding to the LSB.

6. The DAC circuit of any preceding claim, therein the control means is further configured to:
- receive an error associated with a next MSB; and
- generate the control signal further based on the error associated with the next MSB,
- such that when the next MSB is set to 1, a current is transmitted by the plurality of current dividers that compensate the error associated with the next MSB.

7. The DAC circuit of any preceding claim, wherein the control means is further configured to reduce a current provided by a current divider corresponding to the MSB.

8. The DAC circuit of claim 5, wherein the control means is further configured to reduce a current provided by a current divider corresponding to the next MSB.

9. The DAC circuit of claim 1, wherein the plurality of current providing means and switching means forms a R-2R ladder.

10. The DAC circuit of claim 1, wherein the plurality of current providing means are:
- a plurality of current sources (125) such that a current of a current source is double than a current of a consecutive current source; and
- a current divider (120) configured to divide an input current into a first output current and a second output current, wherein the first output current is double that the second output current, and the second output current is double than a current of a first current source among the plurality of current sources (125).

11. The DAC circuit of claim 10, wherein the control means compensate the error associated with the MSB by controlling at least one first switching means among the plurality of first switching means that provides a current corresponding to the binary input signal and the error associated to the MSB.

12. The DAC circuit of any preceding claim, wherein the error is a multiple of a current transmitted to a switching means corresponding to the LSB.

13. The DAC circuit of any preceding claim, wherein the error associated with the MSB is stored in a non-volatile memory.

14. The DAC circuit of any preceding claim, wherein the first path and the second path are connected to an operational transconductance amplifier, OPAMP, (60) for outputting an output current.

15. A method of a Digital-to-Analog Converter (DAC) circuit (10) for outputting an voltage, the DAC circuit comprising a plurality of current providing means (11) connected such that an output current of an each of the current providing means is half of an output current of subsequent current providing means; and a plurality of first switching means (30) connected to each of the current providing means, respectively; each first switching means configured to divert each current into a first path (40) or a second path (50) based on a control signal, the method comprising:
- receive (S101) a binary input signal, the binary input signal comprising a plurality of bits ranging from a most significant bit, MSB, to a least significant bit, LSB, and wherein each bit is associated to a switching means among a plurality of first switching means;
- receive (S102) an error associated with the MSB; and
- modify (S103), when the MSB is set to 1, the binary input signal to generate a control signal based on the binary input signal and the error associated with the MSB, such that a current diverted by at least one of first switching means compensates the error associated with the MSB; and
- generating (S104) an output voltage based on the currents in the first path and the second path.
